# EUROPEAN PATENT APPLICATION

(11) **EP 4 842 190 A1**
(43) Date of publication of application: **18.11.2026**
(21) Application number: 26178727.9
(22) Date of filing: 13.05.2026
(51) Int. Cl.: H10P 95/00

(54) **METHOD FOR WORKPIECE CLEAVING**

(30) Priority: 14.05.2025 US 202519207662
(71) Applicant: NXP USA, Inc, Austin, TX 78735 (US)
(72) Inventor: Reber, Douglas Michael, 5656AG Eindhoven (NL)
(74) Representative: Schwarzweller, Thomas

(57) **Abstract**

A process for cleaving a workpiece after the formation of at least one semiconductor device of the workpiece. The process includes irradiating the workpiece with electromagnetic radiation to heat dopants in a layer in a substrate of the workpiece. The dopants have an absorptance that is at least twice as high as other material of the layer. As a result, the workpiece is heated at the layer which causes the workpiece to split.

## Description

### BACKGROUND OF THE INVENTION

### Field of the Invention

This invention relates cleaving a workpiece after the formation of semiconductor devices.

### Description of the Related Art

Most integrated circuits are formed from processed semiconductor wafers. In some instances, the backside of a wafer may be mechanically polished to reduce the thickness of the wafer after semiconductor devices are formed on the wafer.

### BRIEF DESCRIPTION OF THE DRAWINGS

The present invention may be better understood, and its numerous objects, features, and advantages made apparent to those skilled in the art by referencing the accompanying drawings.
Figure 1 is a partial cutaway side view of a wafer during a stage of manufacture according to some embodiments of present invention.
Figure 2 is a partial cutaway side view of a wafer during a stage of manufacture according to some embodiments of present invention.
Figure 3 is a partial cutaway side view of a wafer during a stage of manufacture according to some embodiments of present invention.
Figure 4 is a partial cutaway side view of a wafer during a stage of manufacture according to some embodiments of present invention.
Figure 5 is a partial cutaway side view of a wafer during a stage of manufacture according to some embodiments of present invention.
Figure 6 is a partial cutaway side view of a wafer during a stage of manufacture according to some embodiments of present invention.
Figure 7 shows a graph of the absorptance over electromagnetic radiation wavelength for different dopants.

The use of the same reference symbols in different drawings indicates identical items unless otherwise noted. The figures are not necessarily drawn to scale.

### DETAILED DESCRIPTION

The following sets forth a detailed description of at least one mode for carrying out the invention. The description is intended to be illustrative of the invention and should not be taken to be limiting.

Described herein is a process for cleaving a workpiece after the formation of at least one semiconductor device of the workpiece. The process includes irradiating the workpiece with electromagnetic radiation to heat dopants in a layer in a substrate of the workpiece. The dopants have an absorptance that is at least twice as high as other material of the layer. As a result, the workpiece is heated at the layer which causes the workpiece to split.

With the manufacture of some integrated circuits, it may be desirable to reduce the thickness of the integrated circuit, e.g., for 3D stacking or for providing increased power density with the implementation back side conductors. However, reducing the thickness of the back side of a relatively thick substrate (e.g. 350 micron) of a wafer may be time consuming and technically challenging.

Previous wafer cleaving methods include implanting helium and/or hydrogen into a layer of the wafer and heating the wafer (e.g. at a temperature in the range of 400 to 600 C). When heated, the helium and hydrogen create gas pockets in the wafer that expand and cause a fracture of the wafer along the implanted areas. However, such a process is not practical for removing a back side portion of the wafer after the formation of semiconductor devices in that some semiconductor device processes may include temperatures exceeding 600 C (e.g. oxidation, annealing) that would cause the helium and hydrogen to expand where the wafer would prematurely fracture.

Accordingly, in some embodiments, providing a workpiece (e.g. such as a wafer, integrated circuit, or semiconductor ribbon) including semiconductor material with a layer of dopants that have a significantly having higher absorptance than the other material of the layer at an electromagnetic wavelength, may provide for a process that can be used to effectively cleave a workpiece after high temperature semiconductor processes are performed on the workpiece without prematurely splitting the workpiece during the high temperature semiconductor processes.

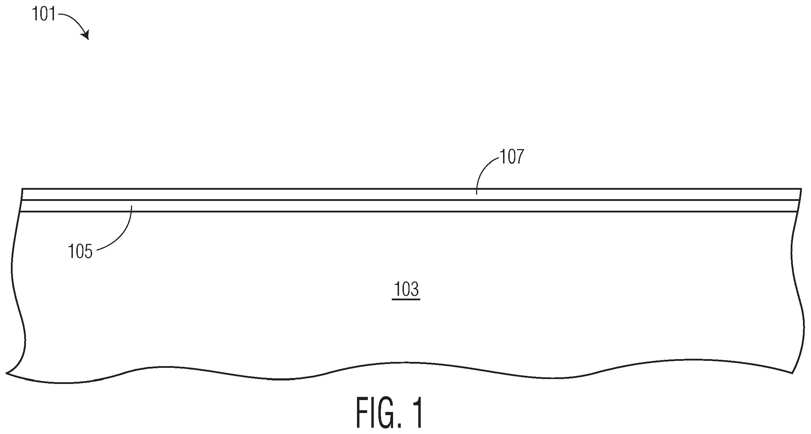

Figure 1 is a cutaway side view of a wafer according to some embodiments of the present invention. Wafer 101 includes a substrate 103, which in some embodiments is made of monocrystalline silicon, but may be made of other types of semiconductor material (e.g., silicon germanium, silicon carbon, gallium nitride, or other III-V semiconductor material) in other embodiments. In the embodiment shown, substrate 103 has a bulk semiconductor configuration. In other embodiments, substrate 103 may have other configurations such an SOI (semiconductor-on-insulator) configuration. In some embodiments, substrate 103 may be formed from a slice of a semiconductor ingot.

Substrate 103 includes a layer 105 of dopants. As will be explained later, the dopants of layer 105 have a high absorptance with respect to the semiconductor material (e.g. silicon) of layer 105 (e.g., at least twice as high). In one embodiment, layer 105 is formed by implanting the absorptive dopants (e.g. by ion implantation) into wafer 101 from the top major side of wafer 101 (relative to the view of Figure 1). In other embodiments, the absorptive dopants of layer 105 may be formed by an in-situ process such that they are formed with epitaxially grown silicon of layer 105 that is grown on an initial portion of substrate 103.

The dopants of layer 105 have a significantly higher absorptance (e.g. at least twice as much) as the absorptance of silicon at a wavelength of electromagnetic radiation that will subsequently be used to cleave wafer 101 after the formation of semiconductor devices in wafer 101 (as will be discussed below). In some embodiments, the absorptive dopants include dopants of a chalcogen such as tellurium, selenium, and/or sulfur. Other the high absorptive dopants may include antimony-doped oxide and cesium doped tin oxide. Absorptance is a measure of the rate of decrease in the intensity of electromagnetic radiation (e.g., light) as it passes through a given substance. Absorptance is equal to 1 when all of the incident radiation is absorbed and is less than 1 when a portion of the radiation is either reflected or transmitted.

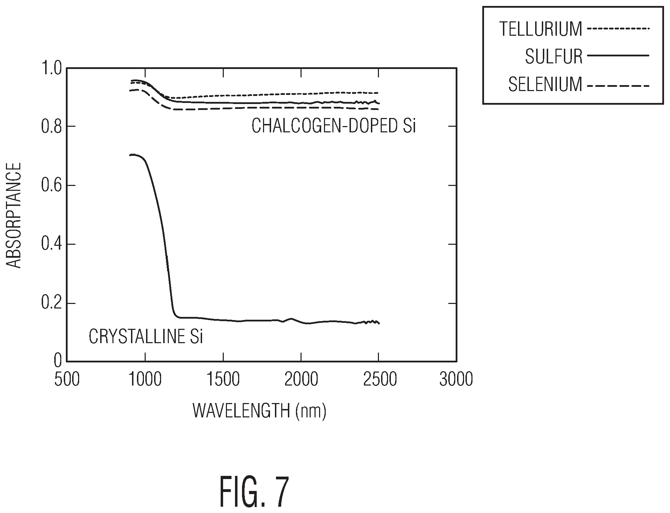

Figure 7 is a graph showing the absorptance of three chalcogens, tellurium, sulfur, and selenium, doped in silicon versus the absorptance of monocrystalline crystalline silicon over an electromagnetic wavelength range from 900 nm to 2500 nm. As shown in Figure 7, the absorptance of silicon drops from about 70 percent at 900nm to around 15 percent at approximately 1200 nm. However, the absorptance of the chalcogen doped silicon remains above 80 percent over the shown range of 1200 nm to 2500nm.

Accordingly, as shown in Figure 7, irradiating a silicon wafer with a doped layer of tellurium, selenium, and/or sulfur with electromagnetic waves in the range of 1200nm to 2500nm with sufficient energy would cause the silicon wafer to heat up more at the layer of dopants than at the rest of the silicon wafer. Heating the absorptive dopants of a layer, preferentially in a very short time interval, causes a split at the layer due to the rapid physical expansion of the layer caused by the confined heat absorption of the dopants.

As shown in Figure 7, tellurium provides the highest absorptance, followed by sulfur, then selenium. One factor that affects the absorptance of a dopant in a semiconductor material is its concentration of the dopants in the semiconductor material. A higher concentration provides for a higher absorptance. When a wafer is heated at high temperatures (e.g. 700 C and above), the dopants may disperse which reduces the concentration of the dopants in the layer. A wafer may be heated during semiconductor processing (e.g., during oxidation, annealing) which may cause the dopants to disperse from their formed position in the wafer, thereby lowering their absorptance. Although Figure 7 shows that sulfur has a higher absorptance than selenium, when a wafer is subject to high temperatures, the sulfur dopants being of a lower atomic weight will disperse farther than the selenium dopants. Hence the heavier weighted dopants such as tellurium may provide a better absorptance if a wafer is subject to high temperature processes prior to cleaving.

Referring back to Figure 1, in some embodiments, the high absorptive dopants of layer 105 are formed in wafer 101 at a depth of less than one micron. In some embodiments, the top of layer 105 is generally between .1 and .4 microns from the top surface of wafer 101 at this stage. However, these depths may be at other distances in other embodiments. In some embodiments, layer 105 may have a thickness in the range of .1 to 1 micron, but may be of other thicknesses in other embodiments.

The transmittance of silicon is fairly constant in a wavelength range from about 1200-6500nm. Outside of that range, the transmittance decreases. Accordingly, outside of that range, the silicon may heat up thereby damaging the wafer and/or the laser may not reach the absorptive dopants with sufficient energy to effectively cleave a wafer.

Table 1 below shows a list of absorptive dopants and parameters for use in a silicon wafer according to some embodiments. For each absorptive dopant listed, Table 1 lists the energies at which the dopants are implanted into a silicon wafer during an implant operation (Implant Energy Range), the projected range of peak dopant concentration depth of implantation (Projected Range) into the silicon wafer, the implant dose of the implant operation (Implant Dose), and the effective wavelength range (Effective Wavelength Range) of electromagnetic radiation used to heat the absorptive dopants during a wafer cleaving operation according to some embodiments.

**TABLE 1**

| Absorptive Dopant Type | Implant Energy Range (keV) | Projected Range (microns) | Implant Dose (atoms/cm2) | Effective Wavelength Range (nm) |
|---|---|---|---|---|
| Tellurium | 50-10,000 | 0.033 ~ 3.75 | 1x10^14-2x10^16 | 1200 nm to 6500nm |
| Selenium | 50-10,000 | 0.038 ~ 4.14 | 1x10^14-2x10^16 | 1200 nm to 6500nm |
| Sulfur | 50-10,000 | 0.063 ~ 4.61 | 1x10^14-2x10^16 | 1200 nm to 6500nm |
| Antimony-doped tin oxide | 50-10,000 for Antimony and Tin; | Antimony 0.0326 ~ 3.73 | 1x10^14-2x10^16 | 1700 nm to 2500nm |
| | 10-1000 for Oxygen | Tin 0.0329 ~ 3.76 | | |
| | | Oxygen 0.0268 ~ 4.06 | | |
| Cesium-doped tungsten oxide | 50-10,000 for Cesium and Tungsten; | Cesium 0.0321 ~ 3.6 | 1x10^14-2x10^16 | 1200 nm to 1800nm |
| | 10-1000 for Oxygen | Tungsten 0.0291 ~ 2.41 | | |
| | | Oxygen 0.0268 ~ 4.06 | | |

Other embodiments may include other values for these parameters. The values of Table 1 may be different where the dopants are implanted into other material such as other semiconductor materials. With other materials, other types of dopants at other wavelengths may be preferable in that the wafer material may have a different absorptance at different wavelengths.

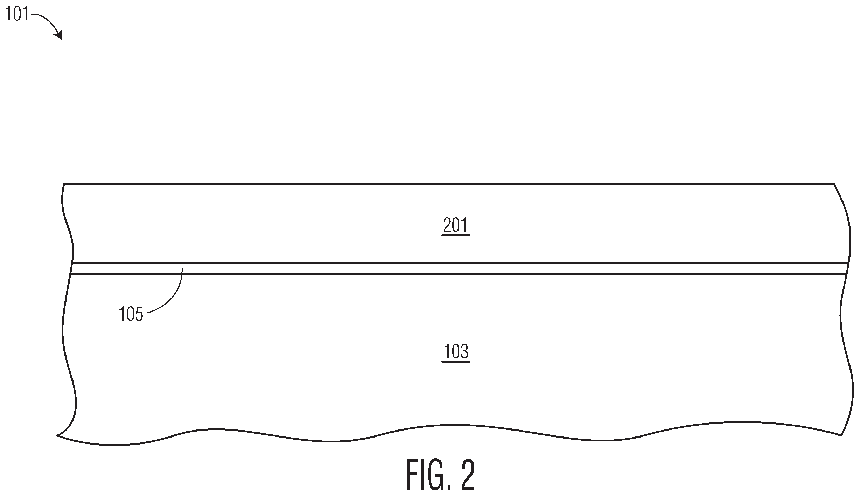

Figure 2 is a partial cutaway side view of wafer 101 after silicon has been epitaxially grown on the top surface of wafer 101, relative to the view shown in Figure 2 to form silicon layer 201, which is a combination of the silicon of layer 107 in Figure 1 and the epitaxially grown silicon. In some embodiments, 4.5 to 5.5 microns of silicon may be grown on wafer 101 during this epitaxial process. However other thicknesses of epitaxial growth may be formed in other embodiments (e.g., in the range of 3-30 microns). In some embodiments, this epitaxial growth acts to increase the amount of active material of the remaining wafer to provide stability after wafer cleavage. Epitaxially growing silicon or other semiconductor material after the implantation of the absorptive dopants may be needed in some embodiments, in that the effectiveness of the implantation of the dopants decreases with deeper implant distances. In other embodiments, the epitaxially grown material may be of another type of semiconductor material such as silicon germanium from the semiconductor material of the wafer. In some embodiments, the absorptive dopants may be implanted to the desired depth without the need for additional epitaxial grown semiconductor material.

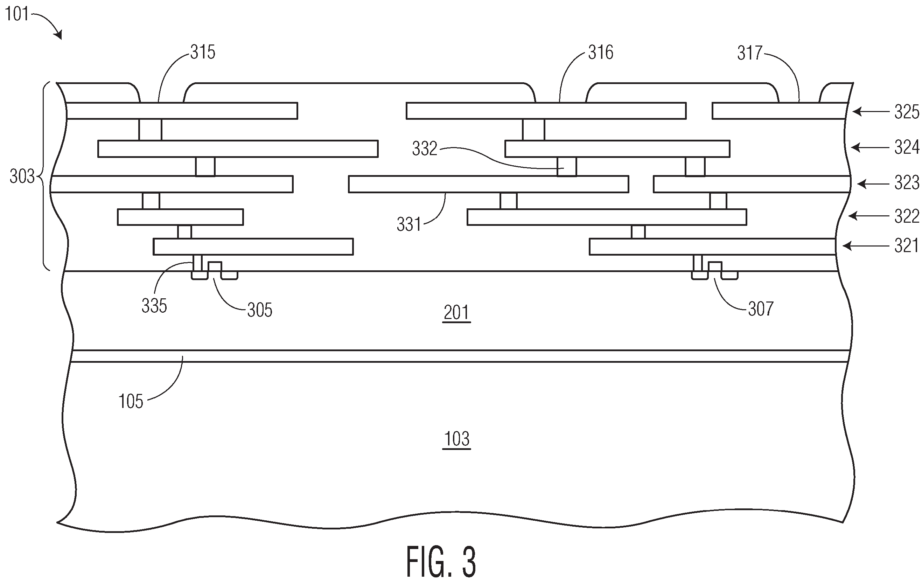

Figure 3 is a partial cutaway side view of wafer 101 after semiconductor devices have been formed above layer 105 and after a backend layer 303 has been formed above layer 201. During wafer processing, semiconductor regions of semiconductor devices such as transistors, resistors, and diodes may be formed in layer 201 by selectively doping regions of layer 201 with conductivity-altering dopants (conductivity dopants) such as N-type dopants (e.g. arsenic and phosphorus) and P-type dopants (boron).

Figure 3 shows transistors 305 and 307 which include semiconductor regions (e.g. source, drain, body terminal regions) located in layer 201. In the embodiment shown, these semiconductor regions extend from the top surface of layer 201 downward. Layer 201 may also include sinker semiconductor regions and buried semiconductor regions, drift regions, and isolation regions (not shown). In Figure 3, transistors 305 and 307 are MOSFETs that include gates located on a relatively thin gate dielectric layer (not shown) located on layer 201. However, a wafer may include other types of semiconductor devices such as other types of transistors, resistors, or diodes in other embodiments. In some embodiments, the semiconductor devices may be located in semiconductor fins formed in layer 207, such as with FinFET transistors. In other embodiments, at least some of the transistors may be all-around gate transistors.

In some embodiments, the formation of the semiconductor regions may include high temperature annealing process or oxidation processes, that may in some embodiments, exceed 700 C. These high temperature processes may cause the dopants in layer 105 to migrate from their implanted positions.

In some embodiments, wafer 101 may include dielectric structures such as isolation trenches, side wall spacers, and other types of isolation structures (not shown) that are formed in layer 201 or above layer 201. These dielectric structures may be made of oxides and nitrides. Some of the oxide dielectric structures may be formed by an oxidation process of the silicon of layer 201 or by an oxidation process of other semiconductor materials.

Wafer 101 includes a backend layer 303 located over substrate 103. Backend layer 303 includes one or more metal layers with metal layers 321-325 being shown in Figure 3. As used herein, a "metal layer" of a backend layer is a layer that includes conductive interconnects (e.g., 331) laterally separated by intralayer dielectric material where at least some of the conductive interconnects of the metal layer provide both a horizontal and a vertical component for a conductive signal path or bias path between semiconductor device terminals of wafer 101 and/or between at least one semiconductor device terminal and at least one external integrated circuit terminal (e.g., a bond pad, bond post, bump - with bond pads 315-317 being shown in Figure 3). In some embodiments, the conductive interconnects of a metal layer are made of a type of conductive material (e.g., copper, gold, aluminum) and may include conductive barrier materials (e.g., tantalum, titanium, tantalum nitride, titanium nitride).

Backend layer 303 includes via layers located in between the metal layers 321-325. The via layers include conductive vias (e.g. via 332) for providing a vertical conductive path between a conductive interconnect of one metal layer (e.g., metal layer 323) and a conductive interconnect of another metal layer (e.g., metal layer 324). The conductive vias may be made of the same type of material as the conductive interconnects. In some embodiments, the vias are contiguous with the interconnects of the immediately above metal layer to implement a multi-layer interconnect structure. The via layers also include intra layer dielectric material (e.g., oxide) that laterally separates the vias in each via layer. Backend layer 303 also includes conductive contacts (e.g., contact 335) for providing a conductive path from terminals of the semiconductor devices (transistor 305) to the interconnects of metal layer 321.

In Figure 3, the dielectric material of the via layers and the dielectric material of the metal layers are shown as a continuous material throughout backend layer 303. However, these dielectric materials may be formed in sequential layers along with the sequential formation of the layers of interconnects and vias. Also, the dielectric structures of layer 303 may include barrier layers and etched stop layers (not shown).

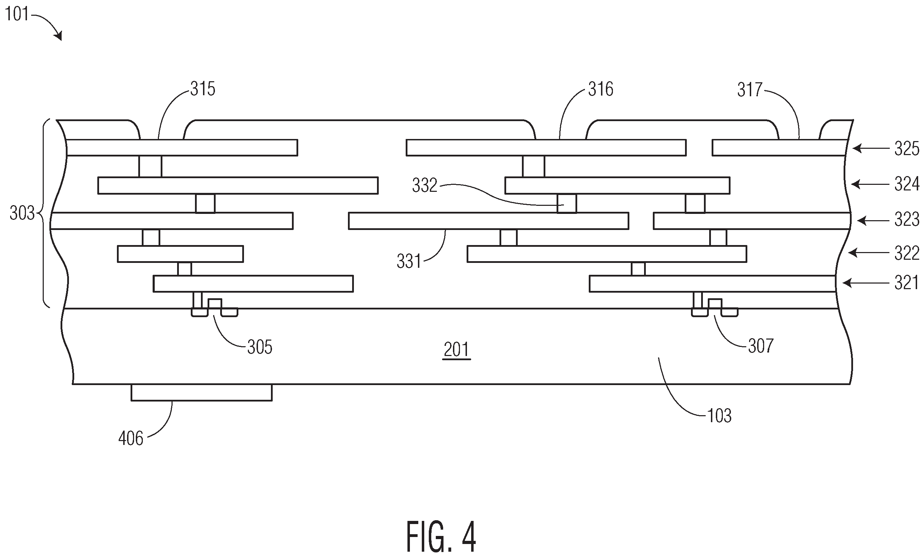

Figure 4 is a partial cutaway side view of wafer 101 after substrate 103 has been cleaved at layer 105 leaving layer 201 as the remaining part of substrate 103. In some embodiments wafer 101 is cleaved by subjecting the bottom major side of substrate 103 to a laser beam that produces electromagnetic radiation at a wavelength whose energy is absorbed by the dopants of layer 105. In some embodiments, it is desirable to keep pulse duration of the laser short (e.g. less than a microsecond range) to prevent the undesirable heating of other regions of the wafer. In some embodiments is that multiple wavelengths may be used. By absorbing the energy of the laser, the dopants of layer 105 heat layer 105 to cause a rapid physical growth in the layer which causes wafer 101 to split (cleave) at layer 105. In other embodiments, other types of devices and processes maybe used to generate electromagnetic radiation for cleaving wafer 101.

After the bottom part (relative to the view of Figure 4) of wafer 103 has been removed, the bottom major side of wafer 103 may be subject to a mechanical polish and/or a relatively light wet etch to planarize the bottom major side. In some embodiments, structures may be added to the bottom side of wafer 101 such as e.g., conductive interconnects (406) that are used to provide signals or power to the semiconductor devices of wafer 101. However, other embodiments may not include such conductive structures on the backside of wafer 101.

Afterwards, wafer 101 is singulated into multiple integrated circuits, where each integrated circuit includes semiconductor devices similar to transistors 305 and 307 and a portion of backend layer 303. The integrated circuits are then protected in semiconductor packages that can be implemented in electronic systems such as e.g., RF communications systems, motor controllers, automotive electronics systems, computers, industrial equipment, appliances, and cellular phones.

Because the thickness of wafer 101 can be significantly reduced as per the cleaving processes described herein, integrated circuits produced from wafer 101 can be relatively thin (e.g. less than 50 microns), thereby allowing for thinner integrated circuit packages. Also, the thinner integrated circuits may be stacked with other integrated circuit in a package, thereby allowing for reduced conductive path impendences between the stacked integrated circuits. Reducing the thickness of a substrate may also allow for better thermal dissipation during operation of an integrated circuit or solar cell. Also, reducing the thickness of a substrate may reduce the complexity in the manufacture of through substrate vias and backside conductors.

With some semiconductor material, e.g., such as with silicon carbide, the semiconductor devices extend from the top major surface to the bottom major surface of an integrated circuit. Therefore, the cleaving processes described herein can reduce the complexity of manufacturing of such "through substrate" devices.

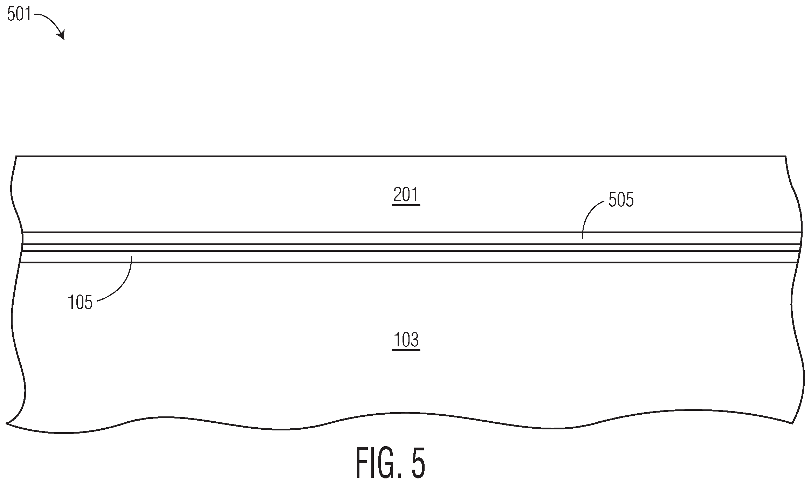

Figure 5 is a partial cutaway side view of wafer 501. Wafer 501 is similar to wafer 101 at the stage of Figure 2, wherein the same reference numbers indicate similar structures. Wafer 501 is different from wafer 101 in that wafer 501 includes a layer 505 of dopants, located above layer 105. In some embodiments, the dopants of layer 505 act to prevent the absorptive dopants of layer 105 from diffusing to the upper portion of substrate 501 during high temperature semiconductor processes. Examples of such diffusion prevention dopants include oxygen, nitrogen, tantalum, titanium, aluminum, or a combination thereof.

In some embodiments, the dopants of layer 505 are implanted or formed in-situ at a location approximately .1 to .4 microns above the top of layer of 105. However, layer 505 may be located at different distances from layer 105 in other embodiments. In some embodiments, the diffusion prevention dopants may be of an implanted dose in the range of 1x10^14-2x10^16 atoms per cm², but may be of other concentrations in other embodiments.

In other embodiments, the dopants of layer 505 may be used to block electromagnetic radiation from reaching the semiconductor device regions located at the top of layer 201 during the cleaving process. In these embodiments, N-type or P-type dopants may be formed in layer 505 at relatively heavy concentrations (e.g. 1X10²¹ per cm³) such that they block the radiation at certain wavelengths (1200-6500 nm) from reaching the semiconductor device regions located at the top major surface of layer 201.

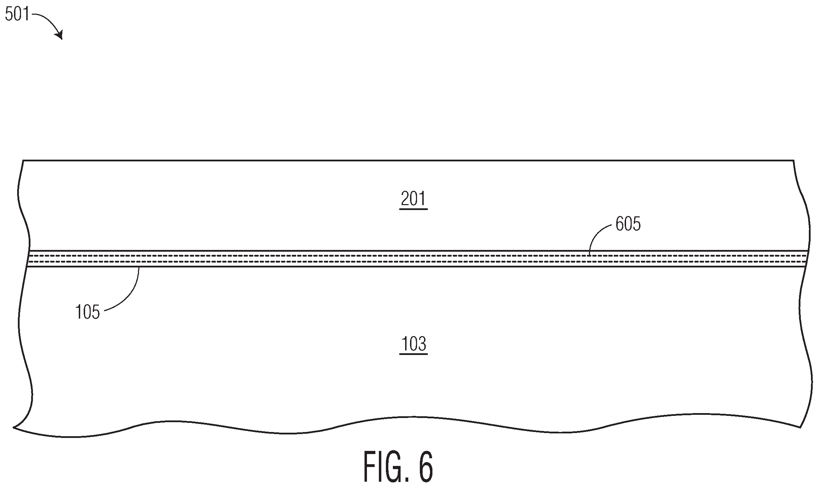

Figure 6 is a partial cutaway side view of a wafer 601 according to another embodiment of the present invention. Wafer 601 is similar to wafer 101 at the stage of Figure 2 where items with the same reference numbers are similar. Wafer 601 differs from wafer 101 in that a layer 605 of helium and/or hydrogen dopants are located within layer 105. The helium or hydrogen dopants aid in the cleaving process by forming gases when heated by the absorptive dopants of layer 105 absorbing electromagnetic radiation energy during a cleaving process. In some embodiments, the helium or hydrogen dopants may have an implanted dose in the range of 1x10^14-2x10^16 atoms/cm², but may be of other concentrations in other embodiments. The concentrations of the helium or hydrogen dopants are not sufficient to cause the wafer to break apart at layer 106 during high temperature semiconductor processes. In other embodiments, layer 605 may be located slightly above layer 105 or slightly below layer 105.

In other embodiments, electromagnetic radiation waves of multiple frequencies may be used in the cleaving process. Also in some embodiments, cleaving processes described herein may be performed on an integrated circuit after it has been sigulated from the wafer (wherein the workpiece would be the integrated circuit in those embodiments). In some embodiments, the absorptive dopants would be formed in non-semiconductor material that would be split during the cleaving process.

In other embodiments, the cleaving processes described herein may be used in the manufacture of solar cells. The cells may be formed in wafers or semiconductor ribbons and include diodes or other semiconductor devices with doped semiconductor regions. After formation of such devices, the workpiece (the wafer or semiconductor ribbon) would be cleaved by the processes described herein. Afterwards, the solar cells may be implemented in solar panels.

As disclosed herein, a first structure is "directly over" a second structure if the first structure is located over the second structure in a line having a direction that is perpendicular with a generally planar major side of the wafer or substate. For example, in Figure 4, transistor 305 is located directly over interconnect 406. Transistor 307 is not directly over interconnect 406. As disclosed herein, a first structure is "directly beneath" or "directly under" a second structure if the first structure is located beneath the second structure in a line having a direction that is perpendicular with a generally planar major side of the wafer or substrate. For example, in Figure 4, via 332 is directly beneath pad 316. Via 332 is not directly beneath pad 315. One structure is "directly between" two other structures in a line if the two structures are located on opposite sides of the one structure in the line. A first structure is "directly lateral" to a second structure if the first structure and second structure are located in a line having a direction that is parallel with a generally planar major side of the wafer or substrate. One structure is "directly laterally between" two other structures if the two structures are located on opposite sides of the one structure in a line that is parallel with a generally planar major side of the wafer or substrate. A surface is at a "higher elevation" than another surface, if that surface is located closer to the top of the active side of a wafer or integrated circuit in a line having a direction that is perpendicular with the generally planar major side of the wafer or die. In the views of Figures 1-6, the active side of the wafer is the top side of the wafer. For example, pad 315 is at a higher elevation than device 305. The term "immediately" when used to describe a relationship between two structures means that there is no intermediate structure between the two structures in the physical relationship.

In some embodiments, a method includes providing a workpiece with a layer of dopants, the dopants have an absorptance of at least twice as much at a first electromagnetic radiation wavelength as other material of the layer, the layer located between a first major side of the workpiece and a second major side of the workpiece, the second major side of the workpiece being opposite the first major side of the workpiece. The method includes forming at least one semiconductor device including regions located in semiconductor material of the workpiece, the regions located between the first major side of the workpiece and the layer. The method includes after forming the at least one semiconductor device, irradiating the workpiece with electromagnetic radiation of at least the first electromagnetic radiation wavelength, wherein the dopants of the layer absorb energy from the electromagnetic radiation thereby heating the workpiece at the layer to cause the workpiece to split, wherein a portion of the workpiece contiguous with the second major side of the workpiece separates from a remaining portion of the workpiece contiguous with the first major side of the workpiece.

In further embodiments of the method, the other material of the layer includes silicon.

In further embodiments of the method, the other material of the layer includes silicon carbide.

In further embodiments of the method, the dopants include tellurium.

In further embodiments of the method, the dopants include selenium.

In further embodiments of the method, the dopants include sulfur.

In further embodiments of the method, the dopants include antimony-doped tin oxide.

In further embodiments of the method, the dopants include cesium doped tungsten oxide.

In further embodiments, the method includes, after forming the dopants in the layer, epitaxially growing semiconductor material on the first major side of the workpiece prior to forming the regions of the at least one semiconductor device.

In further embodiments of the method, the first electromagnetic radiation wavelength is in a range from 1200nm to 6500nm.

In further embodiments of the method, the providing the workpiece with a layer of dopants includes implanting the dopants into the layer from the first major side of the workpiece at a projected range of peak dopant concentration depth of implantation between 0.029 and 4.61 microns.

In further embodiments, the method includes, after the irradiating, forming a back side conductor on a second major side of the remaining portion of the workpiece.

In further embodiments of the method, the electromagnetic radiation is applied from the second major side of the workpiece.

In further embodiments of the method, after the irradiating, the workpiece has a thickness of less than 60 microns between the first major side and a second major side of the remaining portion of the workpiece.

In further embodiments of the method, prior to the irradiating, the workpiece has a thickness of greater than 300 microns between the first major side and the second major side.

In further embodiments of the method, a second layer including dopants is located in the workpiece between the layer and the first major side of the workpiece, wherein the dopants of the second layer inhibit dopants of the layer from migrating towards the first major side of the workpiece.

In further embodiments, the method includes, after forming the regions of the at least one semiconductor device, forming a backend layer on the first major side that includes at least one metal layer including conductive interconnects prior to the irradiating.

In further embodiments of the method, wherein the work piece is a wafer, wherein after the irradiating, the method includes singulating the wafer into a plurality of integrated circuits, wherein each integrated circuit of the plurality includes at least one semiconductor device.

In further embodiments of the method, the irradiating is performed using a laser that produces electromagnetic radiation at the first wavelength.

In further embodiments of the method, the layer includes at least one of the group consisting of hydrogen atoms and helium atoms.

Features specifically shown or described with respect to one embodiment set forth herein may be implemented in other embodiments set forth herein. The use of numerical terms (e.g., "first," "second," "third") in the claims, (e.g., such as in "first opening" and "second opening") are arbitrary designations to differentiate similarly named items (e.g., "openings") and do not imply an order of formation.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true spirit and scope of this invention.

## Claims

1. A method comprising:
providing a workpiece with a layer of dopants, the dopants have an absorptance of at least twice as much at a first electromagnetic radiation wavelength as other material of the layer, the layer located between a first major side of the workpiece and a second major side of the workpiece, the second major side of the workpiece being opposite the first major side of the workpiece;
forming at least one semiconductor device including regions located in semiconductor material of the workpiece, the regions located between the first major side of the workpiece and the layer;
after forming the at least one semiconductor device, irradiating the workpiece with electromagnetic radiation of at least the first electromagnetic radiation wavelength, wherein the dopants of the layer absorb energy from the electromagnetic radiation thereby heating the workpiece at the layer to cause the workpiece to split, wherein a portion of the workpiece contiguous with the second major side of the workpiece separates from a remaining portion of the workpiece contiguous with the first major side of the workpiece.

2. The method of claim 1 wherein the other material of the layer includes silicon.

3. The method of claim 1 or 2 wherein the other material of the layer includes silicon carbide.

4. The method of claim 1 wherein the dopants include at least one of tellurium, selenium, sulfur, antimony-doped tin oxide and cesium doped tungsten oxide.

5. The method of any preceding claim further comprising, after forming the dopants in the layer, epitaxially growing semiconductor material on the first major side of the workpiece prior to forming the regions of the at least one semiconductor device.

6. The method of any preceding claim where the first electromagnetic radiation wavelength is in a range from 1200nm to 6500nm.

7. The method of any preceding claim wherein the providing the workpiece with a layer of dopants includes implanting the dopants into the layer from the first major side of the workpiece at a projected range of peak dopant concentration depth of implantation between 0.029 and 4.61 microns.

8. The method of any preceding claim further comprising after the irradiating, forming a back side conductor on a second major side of the remaining portion of the workpiece.
8. The method of any preceding claim wherein the electromagnetic radiation is applied from the second major side of the workpiece.

9. The method of any preceding claim wherein after the irradiating, the workpiece has a thickness of less than 60 microns between the first major side and a second major side of the remaining portion of the workpiece.

10. The method of claim 9 wherein prior to the irradiating, the workpiece has a thickness of greater than 300 microns between the first major side and the second major side.

11. The method of any preceding claim wherein a second layer including dopants is located in the workpiece between the layer and the first major side of the workpiece, wherein the dopants of the second layer inhibit dopants of the layer from migrating towards the first major side of the workpiece.

12. The method of any preceding claim further comprising, after forming the regions of the at least one semiconductor device, forming a backend layer on the first major side that includes at least one metal layer including conductive interconnects prior to the irradiating.

13. The method of any preceding claim, wherein the work piece is a wafer, wherein the method further includes, after the irradiating, singulating the wafer into a plurality of integrated circuits, wherein each integrated circuit of the plurality includes at least one semiconductor device.

14. The method of any preceding claim wherein the irradiating is performed using a laser that produces electromagnetic radiation at the first wavelength.

15. The method of any preceding claim wherein the layer includes at least one of the group consisting of hydrogen atoms and helium atoms.
